# EUROPÄISCHE PATENTSCHRIFT

(11) **EP 1 665 382 B1**
(45) Veröffentlichungstag und Bekanntmachung des Hinweises auf die Patenterteilung: **12.12.2012**
(21) Anmeldenummer: 04741300.0
(22) Anmeldetag: 28.07.2004
(51) Int. Cl.: H01L 27/146

(54) **OPTOELEKTRONISCHER SENSOR UND VORRICHTUNG ZUR 3D-ABSTANDSMESSUNG**
OPTOELECTRONIC SENSOR AND DEVICE FOR 3D DISTANCE MEASUREMENT
DETECTEUR OPTOELECTRONIQUE ET DISPOSITIF DE MESURE DE DISTANCE EN 3D

(30) Priorität: 18.09.2003 DE 10343709
(43) Veröffentlichungstag der Anmeldung: 07.06.2006
(73) Patentinhaber: iC-Haus GmbH, D-55294 Bodenheim (DE)
(72) Erfinder: HERZ, Manfred, 55130 Mainz (DE)
(74) Vertreter: Kampfenkel, Klaus
(86) Internationale Anmeldenummer: PCT/EP2004/008437
(87) Internationale Veröffentlichungsnummer: WO 2005/036647

(56) Entgegenhaltungen:
- EP-A1- 1 513 202
- WO-A2-02/33922
- DE-A1- 19 704 496
- DE-A1- 19 821 974
- HEINOL H G ET AL: "PHOTOMISCHDETEKTOR ERFASST 3D-BILDER NEUES OPTISCHES BAUELEMENT VEREINIGT DETEKTION UND MISCHUNG" ELEKTRONIK, FRANZIS VERLAG GMBH. MUNCHEN, DE, Bd. 48, Nr. 12, 15. Juni 1999 (1999-06-15), Seite 80,82,84,86,88,90, XP000913168 ISSN: 0013-5658
- Neil H. E. Weste, Kamran Eshraghian: "Principles of CMOS VLSI design", 1993, Addison-Wesley Publishing Co pages 64-67,
- Neil H. E. Weste, Kamran Eshraghian: "Principles of CMOS VLSI design", 1993, Addison-Wesley Publishing Co pages 109-113,

## Beschreibung

Die Erfindung betrifft einen optoelektronischen Sensor zum Demodulieren eines modulierten Photonenstroms, sowie eine wenigstens einen elektronischen Sensor aufweisende Messvorrichtung zur 3D-Abstandsmessung durch Ermittlung der Laufzeit eines modulierten Photonenstroms.

Verfahren und Vorrichtungen zur 3D-Objektvermessung sind hinlänglich bekannt. So ist in der DE 197 04 496 C2 unter anderem ein photonisches Mischelement (PMD, Photonic Mixer Device) beschrieben, welches zur Vermessung passiver Objekte verwendet werden kann. Das photonische Mischelement enthält ein p-dotiertes Siliziumsubstrat, auf welchem mindestens zwei lichtempfindliche Modulationsphotogates angeordnet sind. Den Modulationsphotogates sind ebenfalls auf dem p-dotierten Siliziumsubstrat angeordnete Akkumulationsgates zugeordnet. Die Modulationsphotogates werden mit einer modulierenden Gegentaktspannung betrieben. Auf das p-dotierte Siliziumsubstrat auffallende, intensitätsmodulierte Licht erzeugt Minoritätsladungsträger, die unter dem Einfluss der modulierenden Gegentaktspannung zu den Akkumulationsgates driften und dort aufintegriert werden. Voraussetzung für eine Objektvermessung ist, dass zwischen der Phase der Gegentaktspannungen und der Phase des von einem Sender abgestrahlten, intensitätsmodulierten Lichts eine vorgegebene Phasenbeziehung besteht. Ein Nachteil eines solchen photonischen Mischelementes ist darin zu sehen, dass die Modulationsphotogates und die Akkumulationsgates auf dem Siliziumsubstrat aufgebracht sind, und somit den optischen Sensorbereich des photonischen Mischelementes beschränken. Darüber hinaus ist es nicht möglich, mit den auf dem Siliziumsubstrat angeordneten Modulationsphotogates ein konstantes Driftfeld im Substrat zu erzeugen.

Aus der DE 100 47 170 C2 ist ein PMD-System bekannt, mit dem neben der Intensität auch die Laufzeit einer von einem Sender abgestrahlten und von einem photonischen Mischelement empfangenen intensitätsmodulierten Lichtwelle gemessen werden kann. Die Patentschrift beschäftigt sich jedoch nicht mit der Realisierung von photonischen Mischelementen.

Aus der DE 198 21 974 A1 ist eine Vorrichtung und ein Verfahren zur Erfassung von Phase und Amplitude elektromagnetischer Wellen unter Einsatz von photonischen Mischdetektoren bekannt. Ähnlich dem photonischen Mischdetektor nach der DE 197 04 496 C2 befinden sich Modulationsphotogates und Akkumulationsgates auf einem Halbleitersubstrat. Im Unterschied zu den Modulationsphotogates und Akkumulations-Gates gemäß der DE 197 04 496 C2 weisen die Modulationsphotogates sowie Akkumulations-Gates gemäß der DE 198 21 974 A1 die Form länglicher, schmaler und paralleler Streifen auf.

Die EP 1 513 202 A1, welche als Stand der Technik gemäß Art 54(3) EPÜ gilt, offenbart einen optoelektronischen Sensor gemäß dem Oberbegriff des Anspruchs 1.

Der vorliegenden Erfindung liegt daher die Aufgabe zugrunde, einen optoelektronischen Sensor bereitzustellen, bei dem der Sensorbereich nicht durch Gates abgeschattet wird und bei dem ein im Wesentlichen homogenes Driftfeld erzeugt werden kann.

Ein Kerngedanke der Erfindung ist darin zu sehen, dass das zur Demodulation eines intensitätsmodulierten Photonenstroms erforderliche Driftfeld direkt in einem Halbleiterbereich des Sensors erzeugt wird. Auf diese Weise kann ein homogenes Driftfeld erzeugt werden. Gleichzeitig ist der optische Sensorbereich über dem Halbleiterbereich frei von Elektroden und kann somit in seinen optischen Eigenschaften optimiert werden.

Das oben genannte technische Problem wird zum einen durch einen optoelektronischen Sensor zum Demodulieren eines modulierten Photonenstroms gemäß Anspruch 1. Der modulierte Photostrom ist insbesondere ein intensitätsmodulierter Photostrom.

Hierzu weist der optoelektronische Sensor einen Halbleiterbereich auf, welcher vorzugsweise p-dotiert ist. In dem Halbleiterbereich sind wenigstens zwei Sammelzonen eingebracht, die beispielsweise in den Halbleiterbereich diffundiert und invers zum Halbleiterbereich dotiert sind. Die Sammelzonen dienen dem Sammeln und Abgreifen von Minoritätsträgen dienen, die beim Eindringen eines modulierten Photonenstroms in den Halbleiterbereich erzeugt werden. Weiterhin sind wenigstens zwei Steuerzonen in dem Halbleiterbereich eingebracht, die in Abhängigkeit von einer an die Steuerzonen anlegbaren Steuerspannung ein Driftfeld erzeugen können, wobei die Steuerzonen vom gleichen Dotierungstyp wie der Halbleiterbereich sind.

### Vorteilhafte Weiterbildungen sind Gegenstand der Unteransprüche.

Um in der Nähe der Sammelzonen ein ausreichend starkes Driftfeld erzeugen zu können, weisen die Steuerzonen zum Mittelpunkt des Sensors einen größeren Abstand auf als die Sammelzonen. Auf diese Weise überspannt das Driftfeld die Sammelzonen.

Das oben genannte technische Problem wird ebenfalls durch eine Messvorrichtung gelöst, welche insbesondere zur 3D-Abstandsmessung dienen kann.

Die Messvorrichtung weist wenigstens einen optoelektronischen Sensor nach einem der Ansprüche 1 bis 4 auf. Ferner ist ein optischer Sender vorgesehen, der zum Erzeugen und Abstrahlen eines modulierten, insbesondere intensitätsmodulierten Photonenstrom mit vorbestimmter Phase dient. Ferner ist eine Einrichtung zum Erzeugen einer Steuerspannung vorgesehen, wobei die Phase der Steuerspannung in einer festen Beziehung zur Phase des vom Sender erzeugten Photonenstroms steht. Den Sammelzonen ist eine Auswerteeinrichtung zugeordnet, die zum Ermitteln der Amplitude und Phase des modulierten Photonenstroms mit Bezug auf die Phase der Steuerspannung ausgebildet ist. Es sei angemerkt, dass es sich bei dem optoelektronischen Sensor im Prinzip um einen photonischen Mischdetektor handelt, der beispielsweise einem Pixel eines Kamerachips entsprechen kann. Sofern in dem Halbleiterbereich mehr als ein Sammelzonenpaar zwischen den beiden Steuerzonen eingebettet sind, kann der optoelektronische Sensor auch als ein Mehrpixel-Sensor fungieren. Auf diese Weise kann durch Anordnung mehrerer Sammelzonenpaare auch ein zweidimensionales Pixelarray gebildet werden.

Die Erfindung wird nachfolgend anhand eines Ausführungsbeispiels in Verbindung mit den Zeichnungen näher erläutert.

Es zeigen:
- Fig. 1: einen optoelektronischen Sensor im Querschnitt mit einer angeschalteten, schematisch dargestellten Auswerteeinrichtung, wobei eine Steuerspannung vorbestimmter Polarität an den Steuerzonen angelegt ist,
- Fig. 2: den optoelektronischen Sensor nach Fig. 1, wobei eine umgepolte Steuerspannung an den Steuerzonen angelegt ist,
- Fig. 3 a-e: den Verlauf eines von einem Sender abgestrahlten intensitätsmodulierten Photonenstroms, den Verlauf des auf den in Fig. 1 gezeigten optoelektronischen Sensor auftreffenden Photonenstrom, den Verlauf der Drift- oder Steuerspannung, den Verlauf des aufintegrierten und an der Sammelzone 20 abgegriffenen elektrischen Stroms, und den Verlauf des aufintegrierten und an der Sammelzone 22 abgegriffenen elektrischen Stroms,
- Fig. 4: einen optoelektronischen Sensor im Querschnitt mit einer angeschalteten, schematisch dargestellten Auswerteeinrichtung und zwei Kondensatoren zum kapazitiven Einkoppeln einer Steuerspannung in den Halbleiterbereich, und
- Fig. 5: einen optoelektronischen Sensor im Querschnitt mit einer angeschalteten, schematisch dargestellten Auswerteeinrichtung und zwei in Sperrichtung vorgespannten Dioden zum kapazitiven Einkoppeln einer Steuerspannung in den Halbleiterbereich.

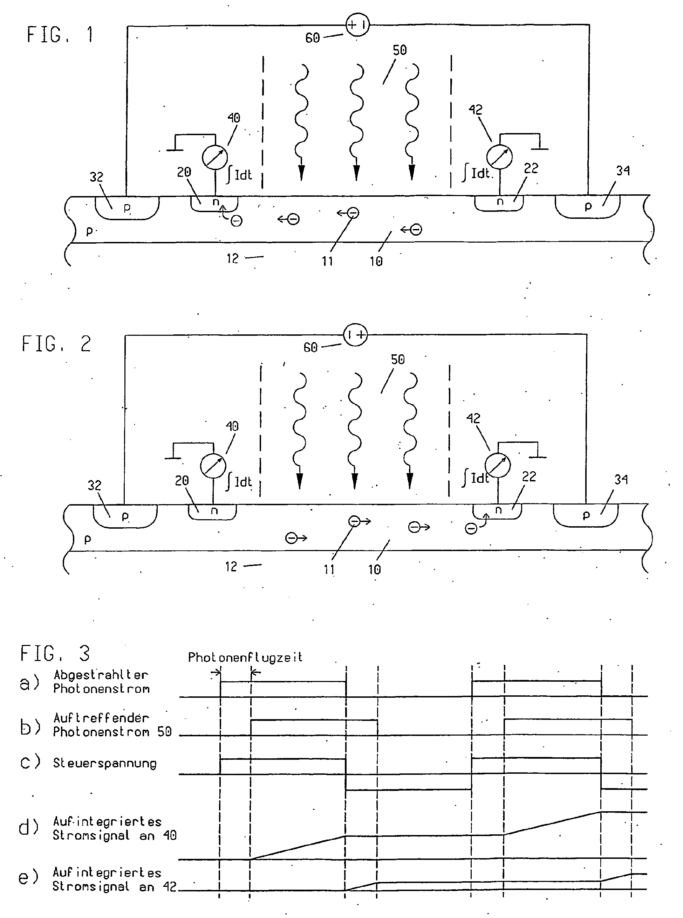

Fig. 1 zeigt einen optoelektronischen Sensor, den man auch als optoelektronischen Detektor bezeichnen kann. Der optoelektronische Sensor weist einen Halbleiterbereich, im vorliegenden Fall eine Halbleiterschicht 10 auf, welche im vorliegenden Beispiel p-dotiert ist. In die Halbleiterschicht 10 sind zwei p-dotierte Zonen 32, 34 eindiffundiert, die nachfolgend als Steuerzonen bezeichnet werden. Ferner sind zwei n-dotierte Zonen 20, 22 in die Halbleiterschicht 10 eindiffundiert, die nachfolgend als Sammelzonen bezeichnet werden. Die Sammelzonen 20 und 22 sowie die Steuerzonen 32 und 34 erstrecken sich von einer Oberfläche der Halbleiterschicht in die Halbleiterschicht 10 hinein. Mit Bezug auf den gedachten Mittelpunkt des Sensors befinden sich die Steuerzonen 32 und 34 weiter außen als die Sammelzonen 20 und 22. An die Steuerzonen 32 und 34 ist eine steuerbare Spannungsquelle 60 angeschlossen, die, wie nachfolgend noch näher erläutert wird, eine in Fig. 3c dargestellte Steuerspannung, auch Driftspannung genannt, erzeugt, um in der Halbleiterschicht 10 ein homogenes Driftfeld zu erzeugen. Ferner ist den Sammelzonen 20 und 22 eine Auswerteeinrichtung zugeordnet, die der einfacheren Darstellung wegen Lediglich durch die beiden Ladungsmesser 40 und 42 symbolisch dargestellt ist. Der Ladungsmesser 40 ist mit der Sammelzone 20 verbunden und misst den an der Sammelzone 20 abgreifbaren, aufintegrierten Strom, dessen zeitlicher Verlauf in Fig. 3d gezeigt ist. Der Ladungsmesser 42 ist mit der Sammelzone 22 verbunden und kann den an der Sammelzone 22 abgreifbaren, aufintegrierten Strom messen, dessen zeitlicher Verlauf in Fig. 3e dargestellt ist.

Fig. 2 zeigt den in Fig. 1 dargestellten optoelektronischen Sensor, wobei lediglich die Polarität der an die Steuerzonen 32 und 34 angelegten Spannungsquelle 60 vertauscht worden ist.

Wie in den Fig. 1 und 2 gezeigt, ist die Halbleiterschicht 10 beispielsweise auf einem Dielektrikum 12 aufgebracht. Nachfolgend wird die Funktionsweise des optoelektronischen Sensors in Verbindung mit einer Messvorrichtung zur 3D-Abstandsmessung hinsichtlich eines nicht dargestellten Objektes erläutert.

Es sei angenommen, dass ein optischer Sender (nicht dargestellt), auch Photonenquelle genannt, einen intensitätsmodulierten Photonenstrom erzeugt und abstrahlt, dessen Verlauf in Fig. 3a dargestellt ist. Der intensitätsmodulierte Photonenstrom wird beispielsweise an einem zu vermessenden Objekt reflektiert und trifft nach einer bestimmten Photonenflugzeit, die in Fig. 3a eingetragen ist, als Photonenstrom 50 auf der aktiven Sensorzone des optoelektronischen Sensors auf, wie dies in Fig. 1 und Fig. 2 dargestellt ist. Der zeitlich verzögerte Photonenstrom 50 ist in Fig. 3b dargestellt. Der in die Halbleiterschicht 10 eindringende Photonenstrom 50 erzeugt in der Halbleiterschicht 10 Ladungsträgerpaare, von denen lediglich die als Minoritätsträger fungierenden Elektronen 11 dargestellt sind. Um die Amplitude und Phase des Photonenstroms 50 bezüglich der Phase der Steuerspannung messen zu können, wird an die p-dotierten Steuerzonen 32 und 34 eine Steuerspannung angelegt, deren Verlauf in Fig. 3c dargestellt ist. Die Steuerspannung kann, wie in Fig. 1 und Fig. 2 dargestellt, durch elektronisches Umschalten der Spannungsquelle 60 erzeugt werden. Wichtige Voraussetzung für eine Objektvermessung ist, dass die Phase des am optischen Sender abgestrahlten Photonenstroms in einer festen Phasenbeziehung zu der Phase der Steuerspannung steht, wie dies durch die in Fig. 3a und 3c dargestellten Kurvenverläufe verdeutlicht wird. Die an den p-dotierten Steuerzonen 32 und 34 angelegte Steuerspannung ruft in der Halbleiterschicht 10 ein Driftfeld hervor, welches im Wesentlichen homogen in der Halbleiterschicht 10 zwischen den Sammelzonen 20 und 22 verläuft. Die Richtung des Driftfeldes wird in Abhängigkeit von der an die Steuerzonen 32 und 34 angelegten Steuerspannung geändert. Auf diese Weise werden die in der Halbleiterschicht 10 erzeugten Minoritätsträger 11 einmal zur Sammelzone 20 hin und einmal zur Sammelzone 22 hin beschleunigt. Beim Unterfliegen der n-dotierten Sammelzonen 20 und 22 können die Elektronen 11 durch die hervorgerufene Raumladungszone eingefangen, in den Sammelzonen 20 und 22 gesammelt und als messbarer elektrischer Strom von der Auswerteeinrichtung 40, 42 abgegriffen werden. Der in Fig. 3c dargestellte Verlauf der Steuerspannung sorgt dafür, dass während einer positiven Steuerspannung ein Driftfeld erzeugt wird, welches, sofern der modulierte Photonenstrom 50 auf die Sensoroberfläche auftrifft, die erzeugten Elektronen 11 zur Sammelzone 20 treibt. Während einer positiven Steuerspannung werden demzufolge die Elektronen 11 an der Sammelzone 20 gesammelt, wodurch ein Stromfluss an der Sammelzone 20 abgreifbar ist. Der in Fig. 3c dargestellte Verlauf der Steuerspannung sorgt ferner dafür, dass während einer negativen Steuerspannung ein Driftfeld erzeugt wird, welches, sofern der intensitätsmodulierte Photonenstrom 50 auf die Sensoroberfläche auftrifft, die erzeugten Elektronen 11 zur Sammelzone 22 treibt. Während einer negativen Steuerspannung werden demzufolge die Elektronen 11 an der Sammelzone 22 gesammelt, wodurch ein Stromfluss an der Sammelzone 22 abgreifbar ist. Der Verlauf des sich in Abhängigkeit des auftreffenden Photonenstroms 50 und der Steuerspannung an der Sammelzone 20 ergebenden aufintegrierten Stroms ist in Fig. 3d dargestellt, während der Verlauf des sich in Abhängigkeit des auftreffenden Photonenstroms 50 und der Steuerspannung an der Sammelzone 22 ergebenden aufintegrierten Stroms in Fig. 3e gezeigt ist.

Die Auswerteeinrichtung 40, 42 ist derart ausgebildet, dass sie die Summe der an den Sammelzone 20 und 22 abgreifbaren, aufintegrierten Ströme bestimmen kann, welche ein Maß für die Amplitude des Photonenstroms 50 ist. Ebenfalls kann die Auswerteeinrichtung 40, 42 das Verhältnis des an der Sammelzone 20 abgreifbaren aufintegrierten Stromes zu dem an der Sammelzone 22 abgreifbaren aufintegrierten Stroms ermitteln, welches ein Maß für die Phase des auf den Sensor auftreffenden Photonenstroms 50 in Bezug auf die Phase des in Fig. 3c dargestellten Steuerspannungsverlaufs ist. Wenn, wie dies in den Figuren 3a und 3c verdeutlicht ist, die Phase des vom Sender erzeugten Photonenstroms gleich der Phase der von der Spannungsquelle 60 erzeugten Steuerspannung ist, ist das Verhältnis der an den Sammelzonen 20 und 22 abgreifbaren, aufintegrierten Ströme ein Maß für die Flugzeit der Photonen von dem zu vermessenden Objekt bis zum Auftreffen auf den Sensor und somit ein Maß für den zurückgelegten Weg der Photonen.

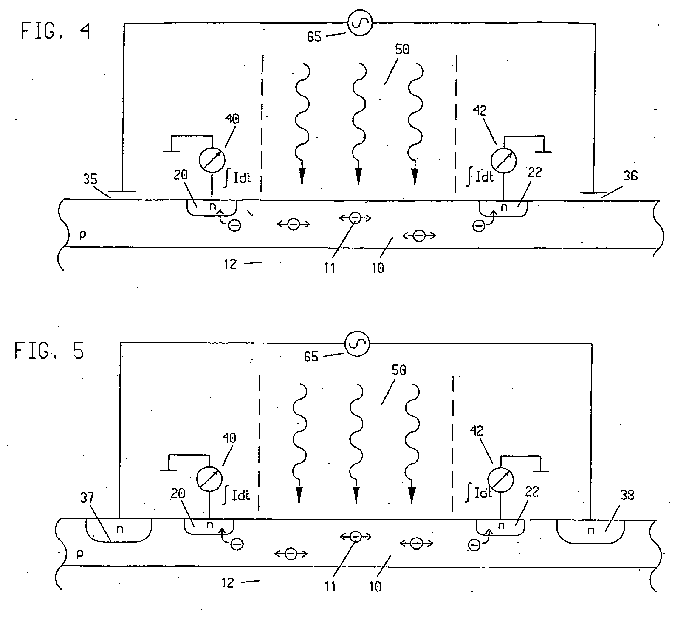

Fig. 4 zeigt einen nicht beanspruchten optoelektronischen Sensor, der sich von dem in Fig. 1 gezeigten optoelektronischen Sensor darin unterscheidet, dass anstelle der Steuerzonen 32 und 34 ein Kondensator 35 bzw. 36 auf der Oberfläche des Halbleiterbereichs 10 aufgebracht ist, an die über eine Wechselspannungsquelle 65 eine Wechselspannung zur Erzeugung eines Driftfeldes im Halbleiterbereich angelegt wird. Die Kondensatoren 35 und 36 sind von den Sammelzonen 20 und 22 räumlich getrennt, wobei die Sammelzonen 20 und 22 zwischen den Kondensatoren 35 und 36 angeordnet sind. Anstelle der Kondensatoren können auch Schottkydioden verwendet werden, die in Sperrrichtung vorgespannt sind.

Fig. 5 zeigt einen nicht beanspruchten optoelektronischen Sensor, der sich von dem in Fig. 1 gezeigten optoelektronischen Sensor darin unterscheidet, dass anstelle der p-dotierten Steuerzonen 32 und 34 n-dotierte Zonen 37 und 38 eingebracht sind, die einen pn-Übergang im Halbleiterbereich 10 bilden und in Sperrrichtung vorgespannt betrieben werden. An die n-dotierten Zonen 37 und 38 ist über eine Wechselspannungsquelle 65 eine Wechselspannung angelegt, die zur Erzeugung eines Driftfeldes zwischen den Sammelzonen 20 und 22 dient. Die Sammelzonen 20 und 22 sind räumlich getrennt von den n-dotierten Zonen 37 und 38 und zwischen diesen angeordnet.

Im Übrigen entspricht der Aufbau der in den Fig. 4 und 5 gezeigten optoelektronischen Sensoren dem Aufbau der in Verbindung mit Fig. 1 und 2 beschriebenen Sensoren. Gleiche Bezugszeichen kennzeichnen somit auch gleiche Merkmale.

## Patentansprüche

1. Optoelektronischer Sensor zum Demodulieren eines modulierten Photonenstroms (50) mit einem Halbleiterbereich (10),
wenigstens zwei in dem Halbleiterbereich (10) vorhandenen Sammelzonen (20, 22) zum Sammeln und Abgreifen von Minoritätsträgern (11), die beim Eindringen eines modulierten Photonenstroms (50) in den Halbleiterbereich (10) zwischen den Sammelzonen erzeugt werden, wobei die Sammelzonen (20, 22) als dotierte Bereiche vorgesehen sind, die invers zum Halbleiterbereich (10) dotiert sind,
wenigstens zwei in dem Halbleiterbereich (10) eingebrachte Steuerzonen (32, 34) zum Erzeugen eines Driftfeldes in Abhängigkeit von der Steuerspannung einer an die Steuerzonen (32, 34) angelegten Steurbaren Sparrungsquelle, wobei die Steuerzonen (32, 34) als dotierte Bereiche vorgesehen sind, die vom gleichen Dotierungstyp wie der Halbleiterbereich (10) sind wobei die Sammelzonen und die Steuerzonen sich von einer Oberfläche der Halbleiterschicht in die Halbleiterschicht hireinerstrecken,
**dadurch gekennzeichnet, dass**
der Halbleiterbereich (10) sich über oder in einem Halbleitersubstrat (12) befindet, welches höher dotiert ist als der Halbleiterbereich (10) oder dass
der Halbleiterbereich (10) auf einem Dielektrikum (12) aufgebracht ist.

2. Optoelektronischer Sensor nach Anspruch 1 ,
**dadurch gekennzeichnet, dass**
die Steuerzonen (32, 34) zum Mittelpunkt des Sensors einen größeren Abstand aufweisen als die Sammelzonen (20, 22).

3. Optoelektronischer Sensor nach Anspruch 1 oder 2,
**dadurch gekennzeichnet, dass**
der Halbleiterbereich (10) p-dotiert ist.

4. Optoelektronischer Sensor nach einem der Ansprüche 1 bis 3,
**dadurch gekennzeichnet, dass**
in dem Halbleiterbereich (10) mehr als ein Sammelzonenpaar zwischen zwei Steuerzonen (32, 34) eingebettet ist.

5. Messvorrichtung insbesondere zur 3D-Abstandsmessung mit
wenigstens einem optoelektronischen Sensor nach einem der Ansprüche 1 bis 4,
einem optischen Sender zum Erzeugen eines modulierten Photonenstroms mit vorbestimmter Phase,
einer Einrichtung (60) zum Erzeugen einer Steuerspannung, wobei die Phase der Steuerspannung in einer festen Beziehung zur Phase des vom Sender erzeugten Photonenstroms steht, und
einer den Sammelzonen (20, 22) zugeordneten Auswerteeinrichtung (40, 42) zum Ermitteln der Amplitude und der Phase des modulierten Photonenstroms mit Bezug auf die Phase der Steuerspannung.

## Claims

1. An optoelectronic sensor for demodulating a modulated photon stream (50), the sensor having a semiconductor area (10),
at least two collecting zones (20, 22) existing in the semiconductor area (10) for collecting and tapping minority carriers (11) which are generated (10), while a modulated photon stream penetrates the semiconductor area (10) between the collecting zones, wherein the collecting zones (20, 22) are provided as doped areas which are doped inversely to the semiconductor area (10),
at least two control zones (32, 34) placed in the semiconductor area (10) for generating a drift field as a function of the control voltage of a controllable voltage source applied to the control zones (32, 34), wherein the control zones (32, 34) are provided as doped areas, which are of the same doping type as the semiconductor area (10), wherein the collecting zones and the control zones extend from a surface of the semiconductor layer into the semiconductor layer,
**characterized in that**
the semiconductor area (10) is arranged above, or in a semiconductor substrate (12) which is higher doped than the semiconductor area (10), or
that the semiconductor area (10) is superimposed on a dielectric (12).

2. The optoelectronic sensor according to claim 1, **characterized in that** the control zones (32, 34) have a larger distance to the central point of the sensor than the collecting zones (20, 22).

3. The optoelectronic sensor according to claim 1 or 2, **characterized in that** the semiconductor zone (10) is p-doped.

4. The optoelectronic sensor according to one of claims 1 to 3, **characterized in that** more than one pair of collecting zones is embedded between two control zones (32, 34), in the semiconductor area (10).

5. A measuring device, in particular for threedimensional distance measurement, the device having at least one optoelectronic sensor according to one of claims 1 to 4, one optical transmitter for generating a modulated photon stream with predetermined phase,
means (60) for generating a control voltage, wherein the phase of the control voltage is in a fixed relationship with the phase of the photon stream generated by the transmitter, and
an evaluation system (40, 42) assigned to the collecting zones (20, 22) for determining the amplitude and the phase of the modulated photon stream, with regard to the phase of the control voltage.

## Revendications

1. Capteur optoélectronique pour démoduler un flux photonique modulé (50) comprenant :
une zone semi-conductrice (10),
au moins deux zones collectrices (20, 22) présentes dans la zone semi-conductrice (10) pour collecter et prélever des porteurs minoritaires (11) qui sont produits entre les zones collectrices lorsqu'un flux photonique modulé (50) pénètre dans la zone semi-conductrice (10), dans lequel les zones collectrices (20, 22) sont prévues en tant que zones présentant un dopage inverse de celui de la zone semi-conductrice (10),
au moins deux zones de commande (32, 34) incorporées dans la zone semi-conductrice (10) pour créer un champ de dérive en fonction de la tension de commande d'une source de tension commandable appliquée aux zones de commande (32, 34), dans lequel les zones de commande (32, 34) sont prévues en tant que zones présentant le même type de dopage que la zone semi-conductrice, les zones collectrices et les zones de commande s'étendant d'une surface de la couche semi-conductrice à l'intérieur de la couche semi-conductrice,
**caractérisé en ce que** :
la zone semi-conductrice (10) est disposée sur ou dans un substrat semi-conducteur (12), lequel présente un dopage supérieur à celui de la zone semi-conductrice (10), ou **en ce que**
la zone semi-conductrice (10) est appliquée sur un diélectrique (12).

2. Capteur optoélectronique selon la revendication 1, **caractérisé en ce que** :
les zones de commande (32, 34) présentent une plus grande distance par rapport au centre du capteur que les zones collectrices (20, 22).

3. Capteur optoélectronique selon la revendication 1 ou 2, **caractérisé en ce que** :
la zone semi-conductrice (10) présente un dopage de type P.

4. Capteur optoélectronique selon l'une quelconque des revendications 1 à 3, **caractérisé en ce que** :
plus d'une paire de zones collectrices est incorporée dans la zone semi-conductrice (10) entre deux zones de commande (32, 34).

5. Dispositif de mesure, en particulier pour la mesure de distance en 3D, comprenant :
au moins un capteur optoélectronique selon l'une quelconque des revendications 1 à 4,
un émetteur optique pour créer un flux photonique modulé ayant une phase prédéterminée,
un dispositif (60) pour créer une tension de commande, dans lequel la phase de la tension de commande présente une relation fixe par rapport à la phase du flux photonique créé par l'émetteur, et
un dispositif d'évaluation (40, 42) associé à l'une des zones collectrices (20, 22) pour déterminer l'amplitude et la phase d'un flux photonique modulé par rapport à la phase de la tension de commande.
